# EUROPEAN PATENT APPLICATION

(11) **EP 4 750 238 A1**
(43) Date of publication of application: **27.05.2026**
(21) Application number: 24923329.7
(22) Date of filing: 24.09.2024
(51) Int. Cl.: H05K 7/20

(54) **ELECTRONIC DEVICE**

(30) Priority: 07.02.2024 CN 202410176381
(71) Applicant: HUAWEI TECHNOLOGIES CO., LTD., Shenzhen 518129 (CN)
(72) Inventor: LIU, Xiaobin, Shenzhen, Guangdong 518129 (CN); XIE, Jian, Shenzhen, Guangdong 518129 (CN); LIU, Xuliang, Shenzhen, Guangdong 518129 (CN); LUO, Yuchen, Shenzhen, Guangdong 518129 (CN)
(74) Representative: Isarpatent
(86) International application number: PCT/CN2024/120752
(87) International publication number: WO 2025/167124

(57) **Abstract**

This application relates to the field of electronic product technologies, and discloses an electronic device. The electronic device includes a main body part and a decoration part disposed on the main body part. The main body part and the decoration part jointly enclose a cavity. An air duct housing is disposed in the cavity, the air duct housing divides the cavity into a first cavity and a second cavity that do not communicate with each other, and the first cavity is a closed cavity. The decoration part is configured to form the second cavity, and the decoration part is provided with an air intake/exhaust vent through which the second cavity communicates with the outside of the electronic device. An orthographic projection of the first cavity on a first plane and an orthographic projection of the second cavity on the first plane at least partially overlap, and the first plane is parallel to a thickness direction of the electronic device. A heat dissipation apparatus is disposed in the second cavity, and the heat dissipation apparatus is configured to dissipate heat for a heat source in the first cavity. The electronic device can meet requirements on a heat dissipation effect, reliability of sealing and waterproofing, and a miniaturization design.

## Description

This application claims priority to Chinese Patent Application No. 202410176381.2, filed with the China National Intellectual Property Administration on February 7, 2024 and entitled "ELECTRONIC DEVICE", which is incorporated herein by reference in its entirety.

### TECHNICAL FIELD

This application relates to the field of electronic product technologies, and in particular, to an electronic device.

### BACKGROUND

Currently, a performance requirement of an electronic device is increasingly high, and power consumption of a corresponding electronic component increases rapidly. As a result, heat consumption of the electronic component is also increasingly high. An air-cooled heat dissipation solution gradually becomes a mainstream heat dissipation solution of the electronic device because of a good heat dissipation effect.

Currently, an air-cooled heat dissipation apparatus is mounted in the electronic device. The electronic device is provided with an air intake/exhaust vent, so that air can flow, to implement heat dissipation. In addition, the air intake/exhaust vent is further provided with a waterproof breathable film, to prevent water vapor from entering. However, the waterproof breathable film hinders air flow. As a result, a heat dissipation effect is poor.

### SUMMARY

To resolve the foregoing technical problem, this application provides an electronic device, including a heat dissipation apparatus. A position of the heat dissipation apparatus is appropriately arranged, so that requirements on a heat dissipation effect, reliability of sealing and waterproofing, and a miniaturization design can be considered.

A first aspect of this application provides an electronic device. The electronic device includes a main body part and a decoration part disposed on the main body part. The main body part and the decoration part jointly enclose a cavity. An air duct housing is disposed in the cavity, the air duct housing divides the cavity into a first cavity and a second cavity that do not communicate with each other, and the first cavity is a closed cavity. The decoration part is configured to form the second cavity, and the decoration part is provided with an air intake/exhaust vent through which the second cavity communicates with the outside of the electronic device. An orthographic projection of the first cavity on a first plane and an orthographic projection of the second cavity on the first plane at least partially overlap, and the first plane is parallel to a thickness direction of the electronic device. A heat dissipation apparatus is disposed in the second cavity, and the heat dissipation apparatus is configured to dissipate heat for a heat source in the first cavity.

In the electronic device, because the first cavity is a closed cavity, the second cavity is an open cavity, and the first cavity and the second cavity do not communicate with each other, water outside the electronic device can only flow in the second cavity isolated from the first cavity, and cannot enter the first cavity, so that the first cavity can implement sealing and waterproof protection for an electronic component in the first cavity. In addition, the open second cavity can provide a sufficiently large air intake/exhaust volume for the heat dissipation apparatus, to effective improve a heat dissipation effect of the heat dissipation apparatus. In addition, the open second cavity is formed by using an existing mechanical part (for example, a decoration part) of the electronic device, and an appearance size of the electronic device may not be increased. In addition, the first cavity and the second cavity share a part of thickness space. Therefore, without additionally increasing the appearance size of the electronic device, it can be further ensured that the second cavity can have sufficient space to place the heat dissipation apparatus, to fully utilize internal space of the electronic device. In conclusion, the electronic device has a heat dissipation function, a miniaturization design, and waterproof sealing performance.

In a possible implementation of the first aspect, the decoration part is a rear cover of a camera. In this way, when forming the second cavity, the decoration part may be further configured to protect the camera, and achieve an appearance decoration effect, so that the electronic device is more visually appealing.

In a possible implementation of the first aspect, the air duct housing is of a tubular structure and includes a first end and a second end. Both the first end and the second end are openings, the first end is hermetically connected to the decoration part, and the second end is hermetically connected to the main body part. In this way, the main body part and the air duct housing jointly enclose the first cavity, and the main body part, the decoration part, and the air duct housing jointly enclose the second cavity.

In a possible implementation of the first aspect, the main body part includes a back housing and a middle frame, and the middle frame includes a bearing plate and a frame body disposed around the bearing plate. The back housing covers the frame body and is hermetically connected to the frame body. The back housing is provided with a first through hole, and the decoration part is hermetically connected to the first through hole. The first end of the air duct housing is hermetically connected to the decoration part, and the second end is hermetically connected to the bearing plate.

In a possible implementation of the first aspect, a hole wall of the first through hole includes a first arc wall, the decoration part includes a second arc wall, and the first arc wall is disposed around an outer circumference of the second arc wall and jointly encloses a waterproof adhesive accommodation groove with the second arc wall. For example, the waterproof adhesive accommodation groove accommodates a waterproof adhesive, to implement sealing and waterproofing.

Because the waterproof adhesive accommodation groove is jointly enclosed by the first arc wall and the second arc wall, a cross section of the waterproof adhesive accommodation groove is also an arc, and can accommodate more waterproof adhesive, to effectively improve reliability of a connection between the main body part and the decoration part. In addition, the first arc wall and the second arc wall may further make a transition between the main body part and the decoration part smoother, to effectively improve appearance aesthetics and refinement of the joint between the main body part and the decoration part.

In a possible implementation of the first aspect, the decoration part further includes a glue blocking wall connected to the second arc wall, and the glue blocking wall is attached to the first arc wall, to avoid leakage of the waterproof adhesive from the waterproof adhesive accommodation groove.

In a possible implementation of the first aspect, hardness of a material of the glue blocking wall is less than hardness of a material of the second arc wall.

Because the hardness of the material of the glue blocking wall is small, in a process of maintaining pressure after dispensing, the glue blocking wall may slightly deform, to release stress, so as to effectively avoid a problem that the back housing cracks because an acting force exerted by the decoration part on the back housing is relatively concentrated, and further reduce assembly difficulty.

In a possible implementation of the first aspect, the material of the glue blocking wall and the material of the second arc wall are nano molding materials. In other words, the second arc wall and the glue blocking wall may be integrally formed by using a nano molding technology, so that molding difficulty is low, and overall connection reliability of a finished product is good. For example, the material of the second arc wall may be metal, and the material of the glue blocking wall may be plastic.

In a possible implementation of the first aspect, the main body part further includes a temperature equalization board, the bearing plate of the middle frame is provided with a second through hole communicating with the second cavity, and the temperature equalization board is located on a side that is of the bearing plate and that is opposite to the back housing, covers the second through hole, and is hermetically connected to the second through hole.

In this way, the temperature equalization board may be configured to enclose the second cavity, can transfer heat of a heat source to the heat dissipation apparatus located in the second cavity, and can further effectively diffuse concentrated heat, to eliminate a hot spot and equalize a temperature, and play an important role in heat dissipation performance of the electronic device.

In a possible implementation of the first aspect, the bearing plate is provided with a slot adapted to the second end of the air duct housing, and the second end of the air duct housing is inserted into the slot, and forms a waterproof adhesive accommodation groove with the slot together. For example, the waterproof adhesive accommodation groove may accommodate a waterproof adhesive, to implement sealing and waterproofing.

It may be understood that the slot and the second end of the air duct housing are in clearance fit. Therefore, assembly precision (or positioning precision) between the slot and the second end of the air duct housing is not high, and assembly is more convenient. In addition, the slot can effectively avoid leakage of the waterproof adhesive from the waterproof adhesive accommodation groove to a screen side, and sealing reliability is good.

In a possible implementation of the first aspect, an opening of the slot is provided with a chamfer. In this way, in a process of assembling the air duct housing and the middle frame, the second end of the air duct housing may be easily inserted into the slot. Assembly difficulty of the air duct housing and the middle frame is low.

In a possible implementation of the first aspect, the decoration part protrudes relative to the back housing in the thickness direction of the electronic device. In this way, the second cavity can have a larger size, to accommodate a heat dissipation apparatus with a larger size and better heat dissipation performance, so as to further improve a heat dissipation effect.

In a possible implementation of the first aspect, the air duct housing is of a groove-shaped structure, and includes a first end and a second end, the first end is a groove opening, faces the decoration part, and is hermetically connected to the decoration part, and the second end is a groove bottom wall, and faces the main body part. In this way, the main body part and the air duct housing jointly enclose the first cavity, and the decoration part and the air duct housing jointly enclose the second cavity.

Because the air duct housing is of a groove-shaped structure, the air duct housing only needs to be hermetically connected to the decoration part through the first end, to enclose the second cavity, and does not need to be hermetically connected to the main body part. In addition, other components (for example, the temperature equalization board and the middle frame) in the main body part do not need to be hermetically connected to each other either. In other words, two sealing paths, namely, a sealing path between the air duct housing and the main body part and a sealing path between other components (for example, the temperature equalization board and the middle frame) in the main body part can be reduced, to further improve a waterproof sealing effect.

In a possible implementation of the first aspect, the electronic device further includes a battery and a connection circuit board. The battery is disposed in the first cavity, and the connection circuit board is configured to electrically connect the heat dissipation apparatus to the battery.

Based on this, the battery of the electronic device can be used to supply power to the heat dissipation apparatus, without connecting to another external power supply. This is simpler and more convenient, and can be better applied to various application scenarios.

In a possible implementation of the first aspect, the air duct housing is provided with a third through hole, the connection circuit board extends from the first cavity to the second cavity through the third through hole, and the third through hole is hermetically connected to the connection circuit board. For example, a gap between the connection circuit board and the third through hole is filled with the waterproof adhesive, to achieve a waterproof and sealing effect.

A size of the third through hole may be set as small as possible, provided that the connection circuit board can pass through the third through hole. In this way, waterproof space that needs to be sealed can be smaller, to further improve a waterproof effect.

In a possible implementation of the first aspect, the first cavity is provided with a mainboard, and the mainboard can control a working status of the heat dissipation apparatus, for example, start or stop the heat dissipation apparatus, or adjust heat dissipation intensity of the heat dissipation apparatus, so that the heat dissipation apparatus can better meet heat dissipation requirements in different application scenarios.

In a possible implementation of the first aspect, the heat dissipation apparatus includes a heat dissipation fan. The heat dissipation fan can blow heat of the heat source out of the electronic device, to implement heat dissipation.

### BRIEF DESCRIPTION OF DRAWINGS

FIG. 1 shows an example structure of a mobile phone according to some embodiments and is a front view of the mobile phone;
FIG. 2 shows an example structure of another mobile phone according to some embodiments and is a side view of the mobile phone;
FIG. 3A is a three-dimensional diagram of a mobile phone according to an embodiment of this application;
FIG. 3B is a sectional view of a mobile phone along a section A-A in FIG. 3A according to an embodiment of this application;
FIG. 4 shows an example structure of a mobile phone that is not provided with a heat dissipation apparatus according to an embodiment of this application;
FIG. 5A is a sectional view that is of a mobile phone along a section A-A in FIG. 3A according to an embodiment of this application and in which a mainboard and a heat dissipation apparatus are not shown;
FIG. 5B is an exploded view of the mobile phone according to an embodiment of this application based on FIG. 5A;
FIG. 6 shows an example structure of a heat dissipation module in a mobile phone according to an embodiment of this application;
FIG. 7 is a partial enlarged diagram of a mobile phone in an area M1 in FIG. 5A according to an embodiment of this application;
FIG. 8A is a partial enlarged diagram of a mobile phone in an M2 area in FIG. 7 according to an embodiment of this application;
FIG. 8B is an exploded view of a main body part and a decoration part in the mobile phone according to an embodiment of this application based on FIG. 8A;
FIG. 9A is a partial enlarged diagram of a mobile phone in an M3 area in FIG. 7 according to an embodiment of this application;
FIG. 9B is an exploded view of a main body part and an air duct housing in the mobile phone according to an embodiment of this application based on FIG. 9A;
FIG. 10A is a sectional view of a mobile phone along a section B-B in FIG. 3A according to an embodiment of this application;
FIG. 10B is a sectional view of a mobile phone along a section C-C in FIG. 10A according to an embodiment of this application;
FIG. 11A is a sectional view of a mobile phone 1' according to an embodiment of this application; and
FIG. 11B is an exploded view of the mobile phone 1' according to an embodiment of this application based on FIG. 11A.

### DESCRIPTION OF EMBODIMENTS

To make the objectives, technical solutions, and advantages of this application clearer, the following further describes the implementations of this application in detail with reference to the accompanying drawings.

This application provides an electronic device, and the electronic device includes a heat dissipation apparatus. The heat dissipation apparatus includes a heat dissipation fan, and is configured to implement air circulation, to dissipate heat for a heat source in the electronic device.

It may be understood that the electronic device provided in this application includes but is not limited to any one of electronic devices that need to dissipate heat and waterproof, such as a mobile phone, a tablet personal computer (tablet personal computer), an e-book reader, a television, a laptop computer (laptop computer), a personal digital assistant (personal digital assistant, PDA), a personal computer (personal computer, PC), a notebook (notebook), a vehicle-mounted device, and a wearable device. This is not specifically limited in this application. In addition, it may be understood that the heat source may be various electronic components, for example, any one of a multimedia application processor (multimedia application processor, MAP), a radio frequency amplifier (radio frequency amplifier, RFA), a power amplifier (power amplifier, PA), a battery management chip (power management IC, PMIC), a chip (for example, a system on chip (system on chip, SOC)), a central processing unit (central processing unit/processor, CPU), or a battery.

For ease of description, the following describes this solution by using an example in which the electronic device is a mobile phone and the heat source is a mainboard. Electronic components such as a processor, a memory, and a communication module may be integrated on the mainboard.

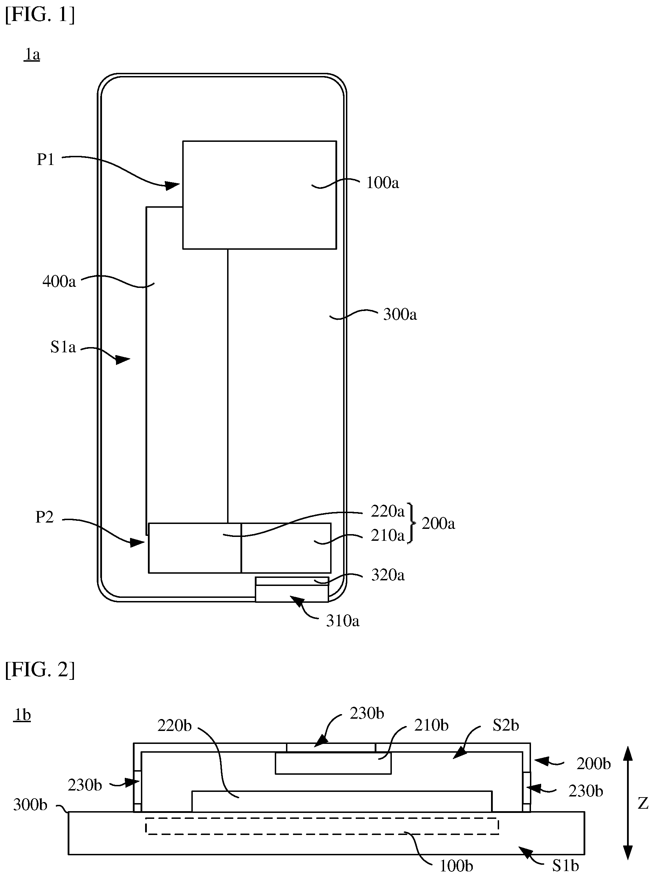

In some embodiments, the heat dissipation apparatus is disposed in the mobile phone. Specifically, FIG. 1 shows an example structure of a mobile phone 1a in some embodiments and is a front view of the mobile phone 1a. Refer to FIG. 1. The mobile phone 1a includes a mainboard 100a, a heat dissipation apparatus 200a, and a housing 300a. The housing 300a encloses a cavity S1a. The mainboard 100a is disposed at a top position P1 of the cavity S1a. The heat dissipation apparatus 200a is an air-cooled heat dissipation apparatus, and includes a heat dissipation fan 210a and a heat dissipation fin 220a. The heat dissipation apparatus 200a is disposed at a bottom position P2 of the cavity S1a. A through hole 310a is provided at a position that is on the housing 300a and that corresponds to the heat dissipation fan 210a, and is used as an air intake/exhaust vent. Based on this, the heat dissipation fan 210a may drive, through the through hole 310a, gas to flow between the inside and the outside of the mobile phone 1a, and the flowing gas can take away heat absorbed by the heat dissipation fin 220a from the mainboard 100a through the heat conducting plate 400a, to implement heat dissipation for the mainboard 100a.

To implement a sealing and waterproof function for the main board 100a, a waterproof breathable film 320a is further disposed on the through hole 310a, so that the cavity S1a can be waterproof and breathable. However, the waterproof breathable film 320a has a small air exhaust volume per unit time, and cannot meet an air intake/exhaust requirement of the normal air-cooled heat dissipation apparatus 200a, thereby causing a poor heat dissipation effect of the heat dissipation apparatus 200a.

Therefore, in some other embodiments, the heat dissipation apparatus is disposed outside the mobile phone. Specifically, FIG. 2 shows an example structure of another mobile phone 1b in some embodiments and is a side view of the mobile phone 1b. Refer to FIG. 2. A housing 300b of the mobile phone 1b encloses a closed cavity S1b, and a mainboard 100b is disposed in the cavity S1b. A front surface of the housing 300b is configured to bear a screen (not shown in the figure), a back surface is provided with an open cavity S2b, and the cavity S2b communicates with the outside through a through hole 230b. Both a heat dissipation fan 210b and a heat dissipation fin 220b of a heat dissipation apparatus 200b are disposed in the cavity S2b, and air intake/exhausting is implemented through the through hole 230b.

In the foregoing solution, because the heat dissipation apparatus 200b is directly disposed outside the cavity S1b, the cavity S1b is not easily eroded by water gas, and therefore a problem of a poor heat dissipation effect caused by a waterproof breathable film can be resolved. However, the heat dissipation apparatus 200b additionally occupies large space (for example, thickness space in a Z direction). As a result, an overall size of the mobile phone 1b (for example, a size of the mobile phone 1b in the Z direction) is large, which is not conducive to a miniaturization design of the mobile phone 1b.

Based on this, this application provides an electronic device. The electronic device can comprehensively meet requirements on a heat dissipation effect, reliability of sealing and waterproofing, and a miniaturization design by appropriately arranging a position of the heat dissipation apparatus. The following describes the technical solutions of this application in detail with reference to the accompanying drawings by using an example in which the electronic device is a mobile phone.

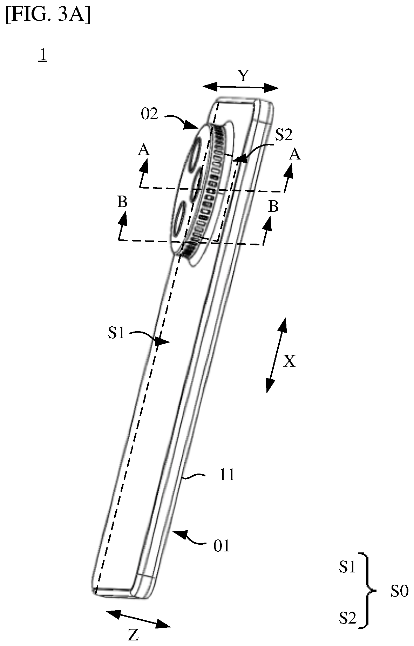

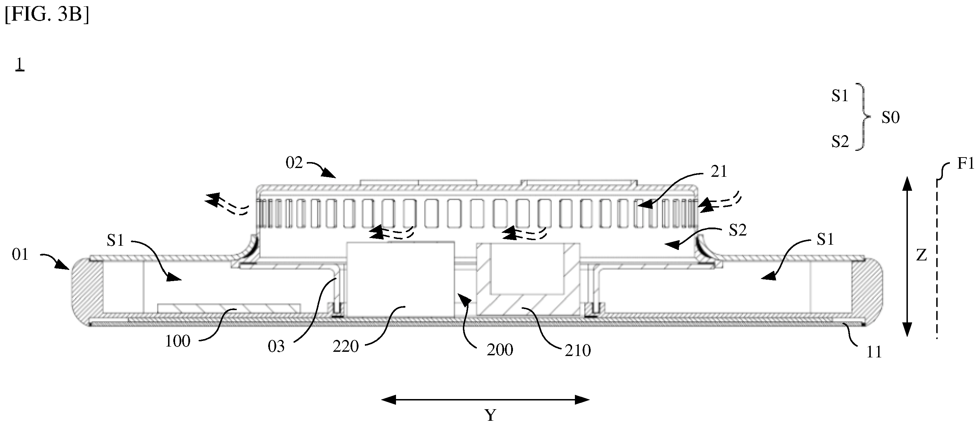

FIG. 3A and FIG. 3B show an example structure of a mobile phone 1 according to an embodiment of this application. FIG. 3A is a three-dimensional diagram of the mobile phone 1. FIG. 3B is a sectional view of the mobile phone 1 along a section A-A in FIG. 3A. Refer to FIG. 3A and FIG. 3B. The mobile phone 1 includes a main body part 01 and a decoration part 02.

The main body part 01 may be generally similar to a cuboid structure. The cuboid structure may include a cuboid structure and a structure similar to a cuboid (for example, an outer surface of the cuboid structure may be partially concave or partially convex). The main body part 01 may include a screen 11. When holding the main body part 01, a user may watch a video, view an image, or perform another touch operation through the screen 11.

The decoration part 02 is disposed on the main body part 01, and is configured to ensure an appearance and performance of the mobile phone 1. For example, as shown in FIG. 3A and FIG. 3B, the decoration part 02 may be disposed on a back surface of the main body part 01, and is used as a rear cover of a camera, to protect a rear-facing camera (not shown in the figure), and also achieve an appearance decoration effect, so that a back surface of the main body part 01 is more visually appealing. The back surface of the main body part 01 may be a surface that is of the main body part 01 and that is opposite to the user when the user holds the main body part 01 with a hand and faces the screen 11.

The main body part 01 and the decoration part 02 jointly form a cavity S0. An air duct housing 03 is disposed in the cavity S0. The air duct housing 03 divides the cavity S0 into a first cavity S1 and a second cavity S2.

The first cavity S1 is a closed cavity. A mainboard 100 is disposed in the first cavity S1. It may be understood that the first cavity S1 may be used as a main cavity of the mobile phone 1, and components accommodated in the first cavity S1 are not limited to the mainboard 100, and may further include an electronic component configured to implement another function of the mobile phone 1, for example, a battery or a camera. Details are not described herein.

The second cavity S2 is an open cavity. A heat dissipation apparatus 200 is disposed in the second cavity S2. The heat dissipation apparatus 200 includes a heat dissipation fan 210 and a heat dissipation fin 220. It may be understood that the second cavity S2 is configured to form an air duct, to implement heat dissipation for the mainboard 100 by the heat dissipation apparatus 200.

For example, the decoration part 02 is provided with a through hole 21, and the through hole 21 communicates the second cavity S2 with the outside of the mobile phone 1, to serve as an air intake/exhaust vent. The heat dissipation fan 210 may drive, through the through hole 21, gas (for example, air) to flow between the inside and the outside of the mobile phone 1. In FIG. 3B, an example flow direction of gas is shown by using a wavy dashed arrow. The flowing gas may take away heat absorbed by the heat dissipation fin 220 from the mainboard 100, for example, reduce a temperature of the heat dissipation fin 220, to implement heat dissipation.

The first cavity S1 and the second cavity S2 do not communicate with each other. In addition, an orthographic projection of the first cavity S1 on a first plane F1 and an orthographic projection of the second cavity S2 on the first plane F1 at least partially overlap. The first plane F1 is parallel to a thickness direction (for example, a Z direction shown in FIG. 3B) of the mobile phone 1. For example, in this embodiment, the first plane F1 may be a plane on which the thickness direction and a length direction (for example, an X direction shown FIG. 3A, or a direction perpendicular to a paper surface in FIG. 3B) of the mobile phone 1 are located. In another embodiment, the first plane F1 may alternatively be a plane on which the thickness direction and a width direction (for example, a Y direction shown FIG. 3B) of the mobile phone 1 are located. For example, the X direction, the Y direction, and the Z direction may be perpendicular to each other.

Because the first cavity S1 of the mobile phone 1 is a closed cavity, the second cavity S2 is an open cavity, and the first cavity S1 and the second cavity S2 do not communicate with each other, water outside the mobile phone 1 can only flow in the second cavity S2 isolated from the first cavity S1, and cannot enter the first cavity S1, so that the first cavity S1 can implement sealing and waterproof protection for an electronic component (for example, the mainboard 100) in the first cavity S1. In addition, the open second cavity S2 can provide a sufficiently large air intake/exhaust volume for the heat dissipation apparatus 200, to effective improve a heat dissipation effect of the heat dissipation apparatus 200.

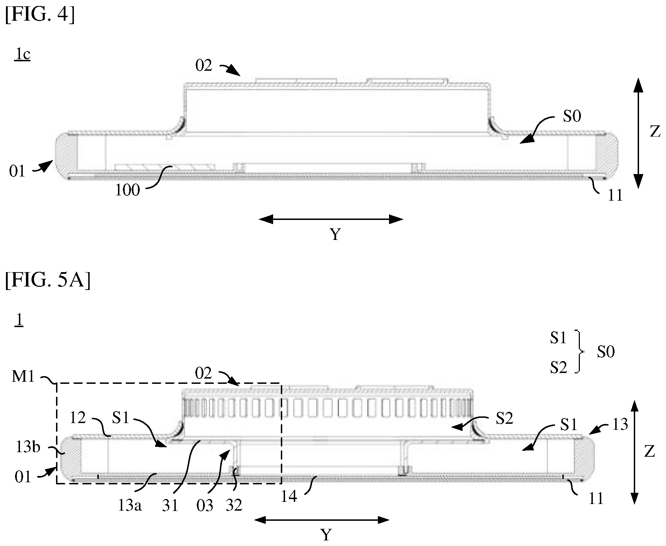

In addition, an existing mechanical part (for example, the decoration part 02) of the mobile phone 1 is used to form the open second cavity S2, and the second cavity S2 and the first cavity S1 share a part of thickness space, so that a heat dissipation function can be implemented without additionally increasing an appearance size of the mobile phone 1. For example, FIG. 4 shows an example structure of a mobile phone 1c that is not provided with a heat dissipation apparatus 200 according to an embodiment of this application. FIG. 3B and FIG. 4 are compared, and the mobile phone 1 that is provided with the heat dissipation apparatus 200 and the mobile phone 1c that is not provided with the heat dissipation apparatus are compared. An appearance change of the mobile phone 1 lies only in that the decoration part 02 is provided with a through hole 12 used to form an air intake/exhaust vent, and no additional appearance size is added. In addition, the first cavity S1 and the second cavity S2 share a part of the thickness space. Therefore, without additionally increasing the appearance size of the mobile phone 1, it can be further ensured that the second cavity S2 can have sufficient space to place the heat dissipation apparatus 200, to fully utilize internal space of the mobile phone 1 and consider both a heat dissipation function and a miniaturization design of the mobile phone 1.

In addition, the heat dissipation apparatus 200 provided in this application may be disposed closer to the mainboard 100, so that a heat dissipation effect is better. For example, as shown in FIG. 1, to consider a layout of another component, the mobile phone 1a is provided with a through hole 310a at a bottom position P2 as an air intake/exhaust vent. Therefore, the heat dissipation apparatus 200a can be disposed only close to the bottom position P2. The heat dissipation apparatus 200a is far away from the mainboard 100a, so that the heat dissipation effect is poor. In this application, the decoration part 02 is provided with a through hole 21 as an air intake/exhaust vent. Therefore, a position of the decoration part 02 may be flexibly adjusted based on an actual situation, so that the heat dissipation apparatus 200 is closer to the mainboard 100 on an XY plane. In addition, the first cavity S1 and the second cavity S2 share a part of the thickness space. Therefore, the heat dissipation apparatus 200 in the second cavity S2 may also be closer to the mainboard 100 in the first cavity S1 in the Z direction, so that a heat dissipation effect is better.

It may be understood that FIG. 3A and FIG. 3B merely show positions of the decoration part 02 as examples. In some other embodiments, the decoration part 02 may alternatively be disposed at another place (for example, a side surface or a front surface) of the main body part 01, and is used as a rear cover of another electronic component (for example, a fingerprint recognition module) in the mobile phone 1. Alternatively, in some other embodiments, the decoration part 02 may be used only to decorate the mobile phone 1, and is not used to protect another component in the mobile phone 1. This is not limited in this application.

In addition, it may be understood that, when being used to enclose the open second cavity S2, the decoration part 02 may further enclose a closed cavity with another component to accommodate an electronic component. For example, when the decoration part 02 is a rear cover of a camera, the decoration part 02 may further enclose a closed cavity with another housing to accommodate the camera, to implement waterproof protection for the camera. In other words, a part of the decoration part 02 may be provided with the through hole 21, to enclose the open second cavity S2, and the other part is not provided with the through hole 21, to enclose a closed cavity. In some other embodiments, the decoration part 02 may alternatively be configured to enclose the open second cavity S2, and is not configured to enclose another closed cavity. This is not limited in this application.

In addition, a shape of the decoration part 02 is not limited in this application. For example, in this embodiment, an overall shape of the decoration part 02 is similar to a cylinder. In another embodiment, a shape of the decoration part 02 may alternatively be a cuboid, a hemisphere, a round table, or another irregular shape.

The following continues to describe, with reference to the accompanying drawings, specific implementations of enclosing the first cavity S1 and the second cavity S2 in the mobile phone 1 and a specific implementation of sealing and waterproofing.

In some implementable solutions, the air duct housing 03 may be similar to a tubular structure extending in the Z direction, and openings at two ends of the air duct housing 03 are hermetically connected to the main body part 01 and the decoration part 02 respectively, to divide the cavity S0 into the first cavity S1 and the second cavity S2. The main body part 01 and the air duct housing 03 jointly enclose the first cavity S1, and the main body part 01, the decoration part 02, and the air duct housing 03 jointly enclose the second cavity S2.

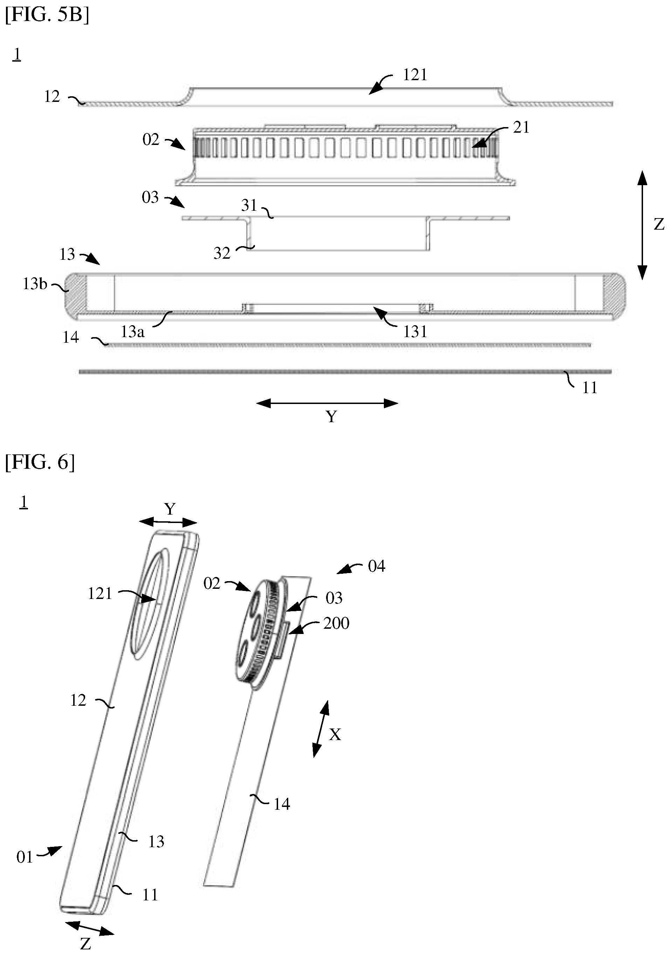

For example, FIG. 5A and FIG. 5B show an example structure of the first cavity S1 and the second cavity S2 in the mobile phone 1 according to an embodiment of this application. FIG. 5A is a sectional view of the mobile phone 1 along a section A-A in FIG. 3A, and does not show the mainboard 100 and the heat dissipation apparatus 200. FIG. 5B is an exploded view of the mobile phone 1. Refer to FIG. 5A and FIG. 5B. In some embodiments of this application, the main body part 01 further includes a back housing 12, a middle frame 13, and a temperature equalization board (temperature equalization board, VC) 14.

The back housing 12 covers the middle frame 13, and is hermetically connected to the middle frame 13. The back housing 12 is provided with a through hole 121 (as an example of a first through hole). The through hole 121 penetrates the back housing 12 in the Z direction. The decoration part 02 is disposed in the through hole 121, and is hermetically connected to the through hole 121. For example, the back housing 12 may be used as a battery rear cover of the mobile phone 1, and is configured to protect a battery (not shown) and another electronic component (for example, the mainboard 100).

The middle frame 13 includes a bearing plate 13a and a frame body 13b. The bearing plate 13a is configured to bear an electronic component (for example, the mainboard 100) and enhance overall strength of the mobile phone 1. The frame body 13b is disposed around the bearing plate 13a, and is configured to hermetically connect to the screen 11 and the back housing 12.

The bearing plate 13a is provided with through hole 131 (as an example of a second through hole). The through hole 131 penetrates the middle frame 13 in the Z direction. The temperature equalization board 14 is located on a side that is of the bearing plate 13a and that is opposite to the back housing 12, covers the through hole 131, and is hermetically connected to the through hole 131. In this way, the temperature equalization board 14 may be exposed through the through hole 131. In other words, a part that is of the temperature equalization board 14 and that is not blocked by the middle frame 13 may be observed through the through hole 131 in a direction from the back housing 12 to the middle frame 13. The temperature equalization board 14 is a pump-free phase-change heat dissipation device, and can effectively diffuse concentrated heat, to eliminate a hotspot and equalize a temperature, and play an important role in heat dissipation performance of the mobile phone 1.

Based on this, the back housing 12, the middle frame 13, and the temperature equalization board 14 of the main body part 01 and the decoration part 02 jointly enclose the cavity S0.

The air duct housing 03 is of a tubular structure and extends in the Z direction. Both a first end 31 and a second end 32 of the air duct housing 03 are openings. The first end 31 is hermetically connected to the decoration part 02. The second end 32 is hermetically connected to the bearing plate 13a of the middle frame 13. In this way, the cavity S0 may be divided into the first cavity S1 and the second cavity S2 by the air duct housing 03. The back housing 12 and the middle frame 13 of the main body part 01 and the air duct housing 03 jointly enclose the first cavity S1. The temperature equalization board 14 of the main body part 01, the decoration part 02, and the air duct housing 03 jointly enclose the second cavity S2. It may be understood that the first cavity S1 is provided around an outer circumference of the second cavity S2 in a circumferential direction of the air duct housing 03.

Refer to FIG. 3B with reference to FIG. 5A and FIG. 5B. Heat generated by the mainboard 100 located in the first cavity S1 may be transferred to the temperature equalization board 14 through the bearing plate 13a of the middle frame 13. Because the temperature equalization board 14 is attached to the heat dissipation fin 220, the temperature equalization board 14 may directly conduct heat to the heat dissipation fin 220 located in the second cavity S2. Finally, the heat dissipation fan 210 dissipates heat on the heat dissipation fin 220 to the outside of the mobile phone 1, to implement heat dissipation for the mainboard 100 by the heat dissipation apparatus 200.

In some embodiments of this application, the second cavity S2 and the heat dissipation apparatus 100 located in the second cavity S2 may jointly enclose a heat dissipation module. FIG. 6 shows an example structure of a heat dissipation module 04 in the mobile phone 1 according to an embodiment of this application. Refer to FIG. 6 with reference to FIG. 3A, FIG. 3B, FIG. 5A, and FIG. 5B. The second cavity S2 is jointly enclosed by the temperature equalization board 14 of the main body part 01, the decoration part 02, and the air duct housing 03. Therefore, the temperature equalization board 14 of the main body part 01, the decoration part 02, the air duct housing 03, and the heat dissipation apparatus 200 may jointly form the heat dissipation module 04. The modular heat dissipation module 04 facilitates quick assembly, to effectively improve assembly efficiency of the mobile phone 1, and can implement independent air tightness measurement, to check an air tightness problem by module before the mobile phone 1 is assembled.

In some embodiments of this application, the decoration part 02 protrudes relative to the back housing 12 of the main body part 01 in the Z direction. In this way, the second cavity S2 has a larger size, to accommodate the heat dissipation fan 210 and the heat dissipation fin 220 with larger sizes and better heat dissipation performance, so as to further improve a heat dissipation effect.

In some embodiments of this application, the decoration part 02 may be provided with a plurality of through holes 21, to form air intake/exhaust vents. In this way, an air intake/exhaust area can be effectively increased, to improve the heat dissipation effect of the heat dissipation apparatus 200. A disposing solution of the air intake/exhaust vents in the mobile phone 1 provided in this application and a disposing solution of the air intake/exhaust vent in the mobile phone 1a in the example shown in FIG. 1 are compared. One through hole 310a is provided in the mobile phone 1a as an air intake/exhaust vent, and the air intake/exhaust vent is on one side, an air intake/exhaust area is small, and a heat dissipation effect is poor. In this application, the plurality of through holes 21 of the mobile phone 1 can form air intake/exhaust vents with larger areas, and a heat dissipation effect is better.

In some implementations, the plurality of through holes 21 are provided around an outer circumferential surface of the decoration part 02. Alternatively, in some other alternative implementations, the plurality of through holes 21 may be further provided at another place of the decoration part 02, for example, on an end surface of the decoration part 02. This is not limited in this application, provided that an air intake/exhaust requirement of the heat dissipation apparatus 200 can be met.

After the example structures of the first cavity S1 and the second cavity S2 of the mobile phone 1 are described, the following continues to describe, with reference to the accompanying drawings, a specific implementation of sealing and waterproofing between components that are used to enclose the cavity S0, the first cavity S1, and the second cavity S2 in the mobile phone 1.

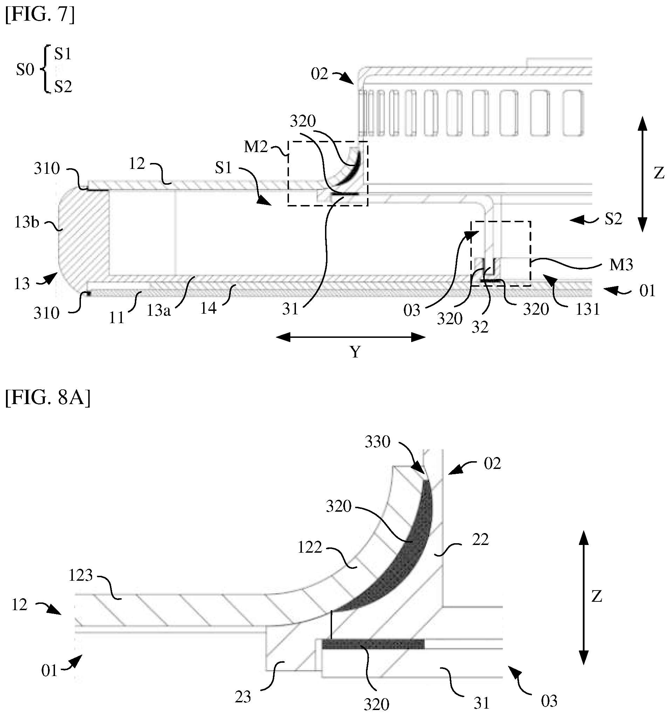

FIG. 7 is a partial enlarged diagram of the mobile phone 1 in an area M1 in FIG. 5A according to an embodiment of this application. Refer to FIG. 7. In the main body part 01, the screen 11 and the frame body 13b of the middle frame 13 are hermetically connected to each other through a waterproof adhesive 310. The back housing 12 and the frame body 13b of the middle frame 13 are hermetically connected to each other through the waterproof adhesive 310. The temperature equalization board 14 and the through hole 131 on the bearing plate 13a of the middle frame 13 are hermetically connected to each other through a waterproof adhesive 320. The decoration part 02 is hermetically connected to the back housing 12 of the main body part 01 through the waterproof adhesive 320, to jointly enclose the cavity S0 with the main body part 01.

In some embodiments of this application, the main body part 01 and the decoration part 02 may be hermetically connected to each other through an arc wall. It may also be understood that a round corner is disposed at a joint between the main body part 01 and the decoration part 02.

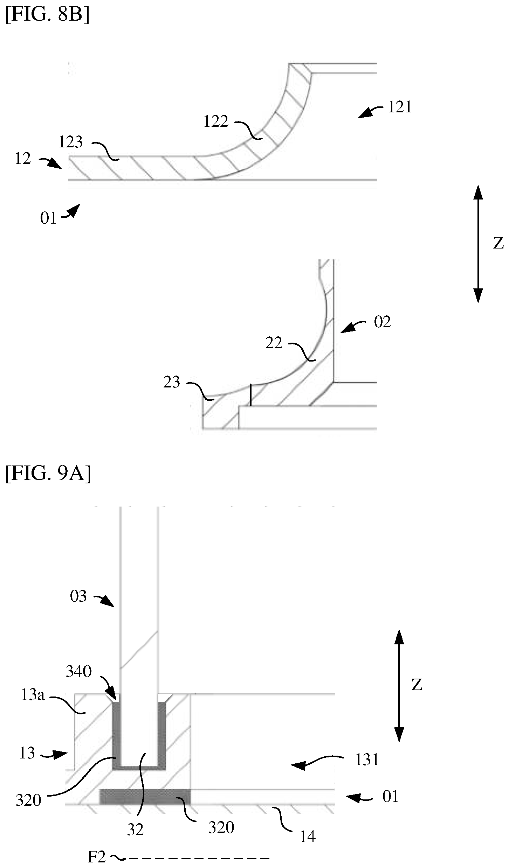

Specifically, FIG. 8A and FIG. 8B are diagrams of hermetically connecting a decoration part 02 to a main body part 01 according to an embodiment of this application. FIG. 8A is a partial enlarged diagram of the mobile phone 1 in an area M2 in FIG. 7. FIG. 8B is an exploded view of the main body part 01 and the decoration part 02 in the mobile phone 1 in FIG. 8A. Refer to FIG. 8A and FIG. 8B. A hole wall of the through hole 121 on the back housing 12 of the main body part 01 includes a first arc wall 122. The first arc wall 122 protrudes relative to a plane part 123 of the back housing 12 in the Z direction, so that a part that is of the back housing 12 and that is near the through hole 121 is similar to a volcanic crater. The decoration part 02 includes a second arc wall 22. For example, a bending degree of the second arc wall 22 may be greater than a bending degree of the first arc wall 22. In other words, a curvature radius of the second arc wall 22 is less than a curvature radius of the first arc wall 122. The first arc wall 122 is disposed around an outer circumference of the second arc wall 22, and jointly encloses a waterproof adhesive accommodation groove 330 with the second arc wall 22. The waterproof adhesive accommodation groove 330 accommodates the waterproof adhesive 320, to implement sealing and waterproofing.

Because the waterproof adhesive accommodation groove 330 is jointly enclosed by the first arc wall 122 and the second arc wall 121, a cross section of the waterproof adhesive accommodation groove 330 is also an arc, and can accommodate more waterproof adhesive 320, to effectively improve reliability of a connection between the main body part 01 and the decoration part 02. In addition, the first arc wall 122 and the second arc wall 121 may further make a transition between the main body part 01 and the decoration part 02 smoother, to effectively improve appearance aesthetics and refinement of the joint between the main body part 01 and the decoration part 02.

In some embodiments of this application, the decoration part 02 further includes a glue blocking wall 23 connected to the second arc wall 22. The glue blocking wall 23 is attached to the first arc wall 122, to avoid leakage of the waterproof adhesive 320 from the waterproof adhesive accommodation groove 330. Hardness of a material of the glue blocking wall 23 is less than hardness of a material of the second arc wall 22.

Because the hardness of the material of the glue blocking wall 23 is small, in a process of maintaining pressure after the back housing 12 and the decoration part 02 are glued through the waterproof adhesive 320, the glue blocking wall 23 may slightly deform, to release stress, so as to effectively avoid a problem that the back housing 12 cracks because an acting force exerted by the decoration part 02 on the back housing 12 is relatively concentrated, and further reduce assembly difficulty.

In some embodiments of this application, the material of the second arc wall 22 and the material of the glue blocking wall 23 may be nano molding (nano molding technology, NMT) materials. In other words, the second arc wall 22 and the glue blocking wall 23 may be integrally formed by using a nano molding technology, so that molding difficulty is low, and overall connection reliability of a finished product is good. For example, the material of the second arc wall 22 may be metal, and the material of the glue blocking wall 23 may be plastic. The nano molding technology is a method in which metal and plastic are combined by using nanotechnology. After a metal surface is nano-processed, plastic is directly injected and formed on the metal surface, so that the metal and the plastic can be integrally formed.

In some embodiments of this application, the waterproof adhesive 310 and the waterproof adhesive 320 may be glues of different types, to achieve a better waterproof effect for different types of structures. For example, a bonding surface between the frame body 13b of the middle frame 13 and both the screen 11 and the back housing 12 is mostly large planes. Therefore, the waterproof adhesive 310 may be a solid waterproof back adhesive. However, a bonding gap between the through hole 131 on the bearing plate 13a of the middle frame 13 and the temperature equalization board 14 is small, and a bonding gap between the decoration part 02 and the back housing 12 is an arc gap. Therefore, the waterproof adhesive 320 may be waterproof hot melt adhesive, and the waterproof hot melt adhesive can more fully fill the irregular (for example, arc-shaped) and narrow gaps, to effectively ensure waterproof reliability.

In some embodiments of this application, two ends of the air duct housing 02 may be respectively hermetically connected to the bearing plate 13a of the middle frame 13 of the main body part 01 and the decoration part 02 through the waterproof adhesive 320, so that the cavity S0 is divided into the first cavity S1 and the second cavity S2.

Still refer to FIG. 8A with reference to FIG. 7. In some embodiments of this application, a bonding surface between the first end 31 of the air duct housing 03 and the decoration part 02 is approximately a plane, and the waterproof adhesive 320 is disposed between the first end 31 and the decoration part 02, to glue the air duct housing 03 and the decoration part 02 together, so as to implement a sealed connection between the air duct housing 03 and the decoration part 02.

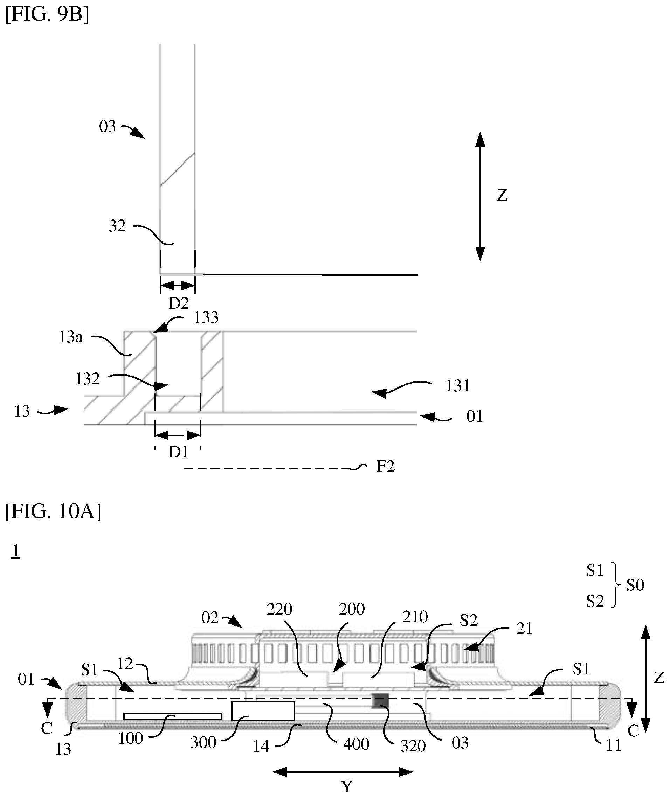

FIG. 9A and FIG. 9B are diagrams of a sealed connection between the air duct housing 03 and the main body part 01 according to an embodiment of this application. FIG. 9A is a partial enlarged diagram of the mobile phone 1 in an area M3 in FIG. 7. FIG. 9B is an exploded view of the main body part 01 and the air duct housing 03 in the mobile phone 1 in FIG. 9A. Refer to FIG. 9A and FIG. 9B. In some embodiments of this application, the air duct housing 03 is hermetically connected to the main body part 01 through a slot.

Specifically, the bearing plate 13a of the middle frame 13 is provided with a slot 132. The slot 132 surrounds an outer circumference of the through hole 131 on the middle frame 13, and an opening faces the air duct housing 03. The slot 132 is adapted to the second end 32 of the air duct housing 03. For example, an orthographic projection of the second end 32 of the air duct housing 03 on a plane (namely, the XY plane, for example, a second plane F2 shown in FIG. 9A and FIG. 9B) perpendicular to the Z direction is a rectangular ring. The orthographic projection of the slot 132 on the second plane F2 may alternatively be a rectangular ring, and a slot width D1 of the slot 132 is slightly greater than a wall thickness D2 of the second end 32 of the air duct housing 03.

The second end 32 of the air duct housing 03 is inserted into the slot 132 and jointly encloses a waterproof adhesive accommodation groove 340 with the slot 132. The waterproof adhesive accommodation groove 340 accommodates the waterproof adhesive 320, to implement sealing and waterproofing.

It may be understood that the slot 132 and the second end 32 of the air duct housing 03 are in clearance fit. Therefore, assembly precision (or positioning precision) between the slot 132 and the second end 32 of the air duct housing 03 is not high, and assembly is more convenient. In addition, the slot 132 can effectively avoid leakage of the waterproof adhesive 320 from the waterproof adhesive accommodation groove 340 to a screen side, and sealing reliability is good.

In some embodiments of this application, a guide part 133 is further disposed on the slot 132, and is configured to guide the second end 32 of the air duct housing 03 to be inserted into the slot 132, to reduce assembly difficulty.

Specifically, the guide part 133 is connected to the slot 132, and a width of the guide part 133 gradually increases in a direction away from the slot 132, and is integrally similar to a horn. Alternatively, it may be understood that a chamfer (for example, an oblique chamfer or a rounded corner) is provided at the opening of the slot 132. In this way, in a process of assembling the air duct housing 03 and the middle frame 13, the second end 32 of the air duct housing 03 may be easily inserted into the guide part 133, and then inserted into the slot 132 through the guide part 133. Assembly difficulty of the air duct housing 03 and the middle frame 13 is low.

In some embodiments of this application, the mobile phone 1 further includes a connection circuit board, and the connection circuit board is configured to connect the heat dissipation apparatus 200 and a battery in the mobile phone 1. In this way, the battery of the mobile phone 1 may supply power to the heat dissipation apparatus 200, and the heat dissipation apparatus 200 does not need to first externally connect to another power supply outside the mobile phone 1 before heat dissipation, and therefore is simple and convenient to use, and has a wide application scope.

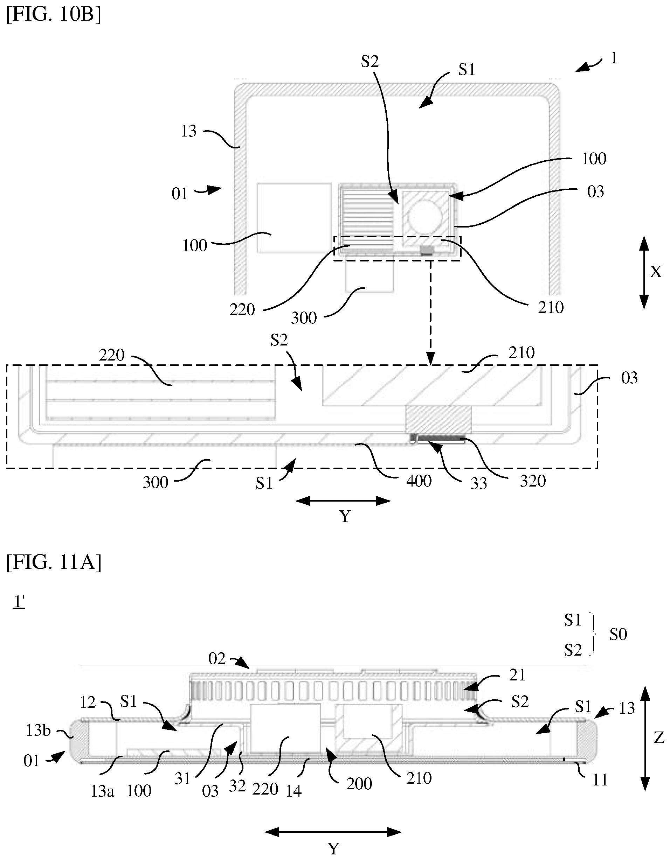

Specifically, FIG. 10A is a sectional view of the mobile phone 1 along a section B-B in FIG. 3A according to an embodiment of this application. FIG. 10B is a sectional view of the mobile phone 1 along a section C-C in FIG. 10A according to an embodiment of this application. Refer to FIG. 10A and FIG. 10B. A battery 300 is disposed in the first cavity S1. The battery 300 may supply power to an electronic component (for example, the mainboard 100) in the mobile phone 1, to ensure that the mobile phone 1 can work normally. The air duct housing 03 is provided with a through hole 33 (as an example of a third through hole). The connection circuit board 400 extends from the first cavity S1 to the second cavity S2 through the through hole 33. In addition, one end of the connection circuit board 400 is electrically connected to the battery 300 located in the first cavity S1, and the other end is electrically connected (for example, connected through spot welding) to a battery contact in the heat dissipation fan 210 located in the second cavity S2. In this way, the battery 300 may transmit electric energy to the heat dissipation fan 210 through the connection circuit board 400, to ensure that the heat dissipation fan 210 can be normally started, to implement heat dissipation.

In addition, the connection circuit board 400 is hermetically connected to the through hole 33, to ensure that the first cavity S1 and the second cavity S2 do not communicate with each other, so as to ensure waterproof reliability of the mobile phone 1. For example, as shown in FIG. 10A and FIG. 10B, a gap between the connection circuit board 400 and the through hole 33 is filled with the waterproof adhesive 320, to achieve a waterproof and sealing effect.

A size of the through hole 33 may be set as small as possible, provided that the connection circuit board 400 can pass through the through hole 33. In this way, waterproof space that needs to be sealed can be smaller, to further improve a waterproof effect.

A disposing solution of the heat dissipation apparatus 200 in the mobile phone 1 provided in this application and a disposing solution of the heat dissipation apparatus 200b in the mobile phone 1b shown in FIG. 2 are compared. The heat dissipation apparatus 200b in the mobile phone 1b is independently disposed outside the mobile phone 1b, needs to be connected to an external power supply for heat dissipation, and consequently, is inconvenient to use, and has a limited application scope. In this application, the heat dissipation apparatus 200 is integrated in the mobile phone 1, and the battery 300 of the mobile phone 1 supplies power to the heat dissipation apparatus 200, without connecting to another external power supply, is simpler and more convenient to use, and can be better used in various application scenarios.

In some embodiments of this application, a working status of the heat dissipation fan 210 (for example, starting or stopping the heat dissipation fan 210 or adjusting a wind speed of the heat dissipation fan 210) may be further controlled through the mainboard 100. The disposing solution of the heat dissipation apparatus 200 in the mobile phone 1 provided in this application and the disposing solution of the heat dissipation apparatus 200b in the mobile phone 1b in the example shown in FIG. 2 are still compared. The mobile phone 1b cannot directly control starting or stopping of the heat dissipation fan 210b through the mainboard 100b in the mobile phone 1b. Consequently, flexibility of using the heat dissipation apparatus 200b is poor, and an application scope is limited. In this application, the heat dissipation apparatus 200 is integrated in the mobile phone 1, and may send different signals to the battery 300 through the mainboard 100, to control the working status of the heat dissipation fan 210, so that the heat dissipation apparatus 200 can better meet heat dissipation requirements in different application scenarios. For example, the mainboard 100 may send, to the battery 300, a signal indicating that the heat dissipation fan 210 is started. After receiving the signal, the battery 300 supplies power to the heat dissipation fan 210, so that the heat dissipation fan 210 starts to work. For another example, the mainboard 100 may further send, to the battery 300, a signal indicating that the heat dissipation fan 210 stops. After receiving the signal, the battery 300 no longer supplies power to the heat dissipation fan 210, so that the heat dissipation fan 210 stops working. For another example, the mainboard 100 may further send, to the battery 300, a signal indicating that the wind speed of the heat dissipation fan 210 is adjusted, so that a current supplied by the battery 300 to the heat dissipation fan 210 increases or decreases, to control the wind speed of the heat dissipation fan 210 to increase or decrease.

In some embodiments of this application, the connection circuit board 400 may be a flexible printed circuit (flexible printed circuit, FPC). The flexible printed circuit is usually made of polyimide or polyester film as a substrate, and has characteristics of free bending, folding, and twisting, to make full use of internal space of the mobile phone 1 for wiring.

It may be understood that, in the foregoing embodiment, the back housing 12 and the middle frame 13 of the main body part 01 and the tubular air duct housing 03 jointly enclose the first cavity S1. The temperature equalization board 14 of the main body part 01, the decoration part 02, and the tubular air duct housing 03 jointly enclose the second cavity S2. This is merely an example for description. This application is not limited thereto. In another embodiment, the first cavity S1 may alternatively be jointly enclosed by another component of the main body part 01 and the tubular air duct housing 03. Similarly, the second cavity S2 may alternatively be jointly enclosed by another component of the main body part 01, the decoration part 02, and the tubular air duct housing 03.

For example, in some alternative implementations, a through hole is provided at a position that is on the bearing plate 13a of the middle frame 13 and that corresponds to the mainboard 100, so that the temperature equalization board 14 may be attached to the mainboard 100. In this way, the back housing 12, the middle frame 13, and the temperature equalization board 14 of the main body part 01 and the air duct housing 03 enclose the first cavity S1. Heat generated by the mainboard 100 located in the first cavity S1 may be directly transferred to the temperature equalization board 14. Then, the temperature equalization board 14 transfers heat to the heat dissipation fin 220, to implement heat dissipation of the mainboard 100 by the heat dissipation apparatus 200.

For another example, in some other alternative implementations, the bearing plate 13a of the middle frame 13 may not be provided with the through hole 131. In other words, the temperature equalization board 14 and the heat dissipation fin 220 are separated by the bearing plate 13a. In this way, the middle frame 13 of the main body part 01, the decoration part 02, and the air duct housing 03 enclose the second cavity S2. The heat dissipation fin 220 located in the second cavity S2 absorbs heat on the temperature equalization board 14 through the middle frame 13, or directly absorbs heat generated by the mainboard 100 through the middle frame 13, and then dissipate heat to the outside of the mobile phone 1. In this way, one sealing path, namely, a sealing path between the temperature equalization board 14 and the bearing plate 13a of the middle frame 13, can be further reduced, to further improve the waterproof sealing effect.

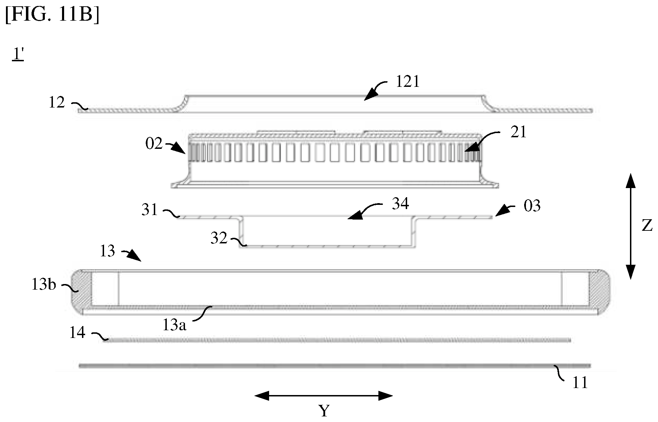

FIG. 11A and FIG. 11B show other example structures of the first cavity S1 and the second cavity S2 in the mobile phone 1' according to an embodiment of this application. FIG. 11A is a sectional view of the mobile phone 1'. FIG. 11B is an exploded view of the mobile phone 1'. The heat dissipation apparatus 200 is not shown in the figure.

Compared with the mobile phone 1 shown in FIG. 5A and FIG. 5B, the mobile phone 1' shown in FIG. 11A and FIG. 11B is different in that a structure of the air duct housing 03 is different, so that a manner of enclosing the second cavity S2 is different, and a quantity of sealing paths is different. The following describes in detail with reference to the accompanying drawings.

Refer to FIG. 11A and FIG. 11B. The air duct housing 03 is of a groove-shaped structure, that is, the first end 31 of the air duct housing 03 includes an opening 34, and the second end 32 is a groove bottom wall. The opening 34 faces the decoration part 02, and is hermetically connected to the decoration part 02. The main body part 01 and the air duct housing 03 jointly enclose the first cavity S1. The decoration part 02 and the air duct housing 03 jointly enclose the second cavity S2.

Because the air duct housing 03 is of a groove-shaped structure, the air duct housing 03 only needs to be hermetically connected to the decoration part 02 through the opening 34, to enclose the sealed second cavity S2, and does not need to be hermetically connected to the bearing plate 13a of the middle frame 13. In addition, in the main body part 01, only the screen 11 needs to be hermetically connected to the frame body 13b of the middle frame 13, and the back housing 12 needs to be hermetically connected to the frame body 13b of the middle frame 13, to jointly enclose the sealed first cavity S1 with the air duct housing 13. The temperature equalization board 14 inside may not be hermetically connected to the bearing plate 13a of the middle frame 13. In other words, two sealing paths, namely, a sealing path between the temperature equalization board 14 and the bearing plate 13a of the middle frame 13 and a sealing path between the air duct housing 03 and the bearing plate 13a of the middle frame 13, in the mobile phone 1' may be reduced, to further improve the waterproof sealing effect.

The following describes several example implementations of enclosing the first cavity S1.

Still refer to FIG. 11A and FIG. 11B. In some implementations, the bearing plate 13a of the middle frame 13 is not provided with a through hole. That is, when observed in a direction from the back housing 12 to the middle frame 13, the temperature equalization board 14 is completely blocked by the middle frame 13. In this way, the back housing 12 and the middle frame 13 of the main body part 01 and the air duct housing 03 jointly enclose the first cavity S1.

In this case, heat generated by the mainboard 100 located in the first cavity S1 may be transferred to the air duct housing 03 through the middle frame 13, and then the air duct housing 03 transfers heat to the heat dissipation fin 220 located in the second cavity S2. Then, the heat dissipation fan 210 dissipates heat on the heat dissipation fin 220 to the outside of the mobile phone 1, to implement heat dissipation for the mainboard 100 by the heat dissipation apparatus 200. In addition, heat generated by the mainboard 100 may be further transferred to the temperature equalization board 14 through the middle frame 13, and the temperature equalization board 14 may spread concentrated heat, to eliminate a hot spot and equalize a temperature, and facilitate heat dissipation.

In some other implementations, the bearing plate 13a of the middle frame 13 is provided with a through hole. The temperature equalization board 14 may be exposed from the through hole, to conduct heat. In this way, the screen 11, the back housing 12, and the middle frame 13 of the main body part 01 and the air duct housing 03 jointly enclose the first cavity S1.

For example, a through hole may be provided at the position that is on the bearing plate 13a of the middle frame 13 and that corresponds to the mainboard 100, so that the temperature equalization board 14 may be attached to the mainboard 100. In this case, heat generated by the mainboard 100 in the first cavity S1 may be diffused through the temperature equalization board 14, and a heat dissipation effect is better.

For another example, a through hole may also be provided at a position that is on the bearing plate 13a of the middle frame 13 and that corresponds to the bottom of the air duct housing 03, so that the temperature equalization board 14 may be attached to the air duct housing 03. In this case, the heat dissipation fin 220 located in the second cavity S2 may absorb heat on the temperature equalization board 14 through the air duct housing 03, and then dissipate heat to the outside of the mobile phone 1'.

The foregoing describes implementations of this application in specific embodiments, and other advantages and effects of this application may be readily understood by a person skilled in the art from content disclosed in this specification. Although this application is described with reference to some embodiments, it does not mean that a characteristic of this application is limited only to this implementation. On the contrary, a purpose of describing this application with reference to an implementation is to cover another option or modification that may be derived based on claims of this application. This application may be alternatively implemented without using these details. In addition, to avoid confusion or blurring a focus of this application, some specific details are omitted from the descriptions. It should be noted that embodiments in this application and the features in embodiments may be mutually combined in the case of no conflict.

In the descriptions of this application, it should be noted that, orientations or position relationships indicated by terms such as "center", "up", "down", "left", "right", "vertical", "horizontal", "outer side", "inner side", "circumferential direction", "radial direction", and "axial direction" are based on the orientations or position relationships shown in the accompanying drawings, and are merely intended to describe this application and simplify the descriptions, but are not intended to indicate or imply that an indicated apparatus or element needs to have a specific orientation or be constructed and operated in a specific orientation, and therefore cannot be understood as a limitation on this application.

In the descriptions of this application, it should be noted that unless otherwise explicitly specified and limited, terms such as "dispose", "mount", "connect", and "attach" should be understood in a broad sense. For example, such terms may indicate a fixed connection, a detachable connection, or an integral connection, may indicate a mechanical connection or an electrical connection, and may indicate a direct connection, an indirect connection through an intermediate medium, or internal communication between two elements. A person of ordinary skill in the art may understand a specific meaning of the foregoing term in this application according to a specific situation.

It is clearly that a person skilled in the art can make various modifications and variations to this application without departing from the spirit and scope of this application. This application is intended to cover these modifications and variations of this application provided that they fall within the scope of the claims of this application and equivalent technologies thereof.

## Claims

1. An electronic device, comprising a main body part and a decoration part disposed on the main body part, wherein
the main body part and the decoration part jointly enclose a cavity, an air duct housing is disposed in the cavity, the air duct housing divides the cavity into a first cavity and a second cavity that do not communicate with each other, the first cavity is a closed cavity, the decoration part is configured to form the second cavity, and the decoration part is provided with an air intake/exhaust vent through which the second cavity communicates with the outside of the electronic device;
an orthographic projection of the first cavity on a first plane and an orthographic projection of the second cavity on the first plane at least partially overlap, and the first plane is parallel to a thickness direction of the electronic device; and
a heat dissipation apparatus is disposed in the second cavity, and the heat dissipation apparatus is configured to dissipate heat for a heat source in the first cavity.

2. The electronic device according to claim 1, wherein the decoration part is a rear cover of a camera.

3. The electronic device according to claim 1, wherein the air duct housing is of a tubular structure and comprises a first end and a second end, both the first end and the second end are openings, the first end is hermetically connected to the decoration part, and the second end is hermetically connected to the main body part.

4. The electronic device according to claim 3, wherein the main body part comprises a back housing and a middle frame, and the middle frame comprises a bearing plate and a frame body disposed around the bearing plate;
the back housing covers the frame body and is hermetically connected to the frame body, the back housing is provided with a first through hole, and the decoration part covers the first through hole and is hermetically connected to the first through hole; and
the first end of the air duct housing is hermetically connected to the decoration part, and the second end is hermetically connected to the bearing plate.

5. The electronic device according to claim 4, wherein a hole wall of the first through hole comprises a first arc wall, the decoration part comprises a second arc wall, and the first arc wall is disposed around an outer circumference of the second arc wall and jointly encloses a waterproof adhesive accommodation groove with the second arc wall.

6. The electronic device according to claim 5, wherein the decoration part further comprises a glue blocking wall connected to the second arc wall, and the glue blocking wall is attached to the first arc wall.

7. The electronic device according to claim 6, wherein hardness of a material of the glue blocking wall is less than hardness of a material of the second arc wall.

8. The electronic device according to claim 6, wherein a material of the glue blocking wall and a material of the second arc wall are nano molding materials.

9. The electronic device according to claim 4, wherein the main body part further comprises a temperature equalization board, the bearing plate of the middle frame is provided with a second through hole communicating with the second cavity, and the temperature equalization board is located on a side that is of the bearing plate and that is opposite to the back housing, covers the second through hole, and is hermetically connected to the second through hole.

10. The electronic device according to claim 4, wherein the bearing plate is provided with a slot adapted to the second end of the air duct housing, and the second end of the air duct housing is inserted into the slot and jointly encloses a waterproof adhesive accommodation groove with the slot.

11. The electronic device according to claim 10, wherein an opening of the slot is provided with a chamfer.

12. The electronic device according to claim 4, wherein the decoration part protrudes relative to the back housing in the thickness direction of the electronic device.

13. The electronic device according to claim 1, wherein the air duct housing is of a groove-shaped structure and comprises a first end and a second end, the first end is a groove opening, faces the decoration part, and is hermetically connected to the decoration part, and the second end is a groove bottom wall and faces the main body part.

14. The electronic device according to claim 1, wherein the electronic device further comprises a battery and a connection circuit board, the battery is disposed in the first cavity, and the connection circuit board is configured to electrically connect the heat dissipation apparatus to the battery.

15. The electronic device according to claim 14, wherein the air duct housing is provided with a third through hole, the connection circuit board extends from the first cavity to the second cavity through the third through hole, and the third through hole is hermetically connected to the connection circuit board.

16. The electronic device according to claim 1, wherein a mainboard is disposed in the first cavity, and the mainboard is capable of controlling a working status of the heat dissipation apparatus.

17. The electronic device according to claim 1, wherein the heat dissipation apparatus comprises a heat dissipation fan.
